# EUROPÄISCHE PATENTSCHRIFT

(11) **EP 1 467 407 B1**
(45) Veröffentlichungstag und Bekanntmachung des Hinweises auf die Patenterteilung: **03.12.2008**
(21) Anmeldenummer: 04006022.0
(22) Anmeldetag: 13.03.2004
(51) Int. Cl.: H01L 25/07, H01L 25/16

(54) **Leistungshalbleitermodul**
Power semiconductor module
Module semiconducteur de puissance

(30) Priorität: 10.04.2003 DE 10316355
(43) Veröffentlichungstag der Anmeldung: 13.10.2004
(73) Patentinhaber: SEMIKRON Elektronik GmbH & Co. KG, 90431 Nürnberg (DE)
(72) Erfinder: Stockmeier, Thomas, Dr., 90431 Nürnberg (DE); Steger, Jürgen, 91355 Hilpoltstein (DE)

(56) Entgegenhaltungen:
- EP-A- 1 032 042
- EP-A- 1 289 014
- WO-A-02/058152
- US-A- 4 965 710
- US-A1- 2002 070 439
- US-B1- 6 421 244

## Beschreibung

Die Erfindung beschreibt ein Leistungshalbleitermodul bestehend aus einem Gehäuse mit Grundplatte oder zur direkten Montage auf einem Kühlkörper und mindestens einem darin angeordneten elektrisch isolierenden Substrat. Dieses besteht seinerseits aus einem Isolierstoffkörper mit einer Mehrzahl darauf befindlicher gegeneinander isolierter metallischer Verbindungsbahnen und auf diesen befindlichen und mit diesen Verbindungsbahnen schaltungsgerecht verbundenen Leistungshalbleiterbauelementen. Vorteilhafterweise weist das Substrat auf seiner Unterseite eine flächige metallische Schicht, vergleichbar den Verbindungsbahnen, auf. Weiterhin weisen derartige Leistungshalbleitermodule Anschlusselemente für Last- und Hilfskontakte auf.

Leistungshalbleitermodule, die Ausgangspunkt dieser Erfindung sind, sind beispielhaft bekannt aus DE 42 37 632 A1 und DE 196 30 173 C2. Derartige Leistungshalbleitermodule weisen zumindest teilweise als Kontaktfedern ausgebildete Anschlusselemente zur Verbindung der Verbindungsbahnen des Substrates mit externen Anschlüssen auf. Diese Kontaktfedern sind derart im Leistungshalbleitermodul angeordnet, dass sie die Anschlussbelegung im Inneren des Substrates auf die äußeren Anschlüsse abbilden.

Nachteilig an o.g. Stand der Technik ist, dass die äußere Anschlussbelegung somit durch die interne direkt vorgegeben ist. Äußere Beschaltungen, wie beispielhaft Treiberschaltungen, müssen daher an die interne Anschlussbelegung des Leistungshalbleitermoduls angepasst werden.

Beispielhaft aus der DE 100 25 696 A1 ist ein weiteres Leistungshalbleitermodul bekannt, welches eine senkrecht zum Substrat angeordnete Leiterplatte offenbart. Diese Leiterplatte ist mit einem Teilbereich im Inneren und mit einen weiteren Teilbereich außerhalb des Leistungshalbleitermoduls angeordnet und bildet somit dessen Anschlusselemente.

Nachteilig hierbei ist, dass durch die Lage der Leiterplatte ebenfalls die äußere Anschlussbelegung festgelegt wird.

Zum Stand der Technik zählt weiterhin die US 4,965,710 welche ein Leistungshalbleitermodul mit einer im Modulinneren angeordneten Treiberschaltung offenbart. Diese Treiberschaltung ist über potentialtrennende Schaltungsteile, wie Optokoppler mit äußeren Anschlusselementen verbunden. Weiterhin zum Stand der Technik zählt die EP 1 032 042 A2 welche ebenfalls ein Leistungshalbleitermodul mit integrierter Treiberschaltung offenbart. Hierin werden Hilfsanschlusselemente von einem Substrat nach außen geführt und kontaktieren hierbei die im Inneren des Moduls angeordnete Leiterplatte der Treiberschaltung. Die WO 02/057152 A2 offenbart verschiedene Ausgestaltungen von Federelementen im Inneren eines Leistungshalbleitermoduls.

Ebenso ist aus der EP 1 289 014 A1 ein Leistungshalbleitermodul bekannt mit Anschlusselementen nach dem Stand der Technik.

Der vorliegenden Erfindung liegt daher die Aufgabe zu Grunde ein Leistungshalbleitermodul vorzustellen, bei dem die interne Anschlussbelegung der Hilfsanschlüsse schaltungsgerecht ausgeführt ist und durch einfache Maßnahmen an eine davon abweichende äußere Anschussbelegung der Hilfsanschlüsse, beispielhaft für Treiberschaltungen, angepasst werden kann.

Diese Aufgabe wird gelöst durch ein Leistungshalbleitermodul nach dem Anspruch 1, spezielle Ausgestaltungen finden sich in den Unteransprüchen.

Der Grundgedanke der Erfindung geht aus von einem Leistungshalbleitermodul mit einer Grundplatte oder zur direkten Montage auf einem Kühlkörper nach dem genannten Stand der Technik bestehend aus einem rahmenartigen Gehäuse mit mindestens einem darin angeordneten elektrisch isolierenden Substrat und einem Deckel. Dieses Substrat besteht seinerseits aus einem Isolierstoffkörper mit einer Mehrzahl von auf seiner ersten Hauptfläche befindlichen gegeneinander isolierten metallischen Verbindungsbahnen sowie vorzugsweise aus einer auf seiner zweiten Hauptfläche angeordneten flächigen metallischen Schicht. Auf den Verbindungsbahnen der ersten Hauptfläche und mit diesen Verbindungsbahnen schaltungsgerecht verbunden ist eine Mehrzahl von Leistungshalbleiterbauelementen angeordnet. Das erfinderische Leistungshalbleitermodul weist nach außen führende Anschlusselemente für Last- und Hilfskontakte auf. Zumindest ein Teil dieser Anschlusselemente der Hilfsanschlüsse wird im Inneren des Leistungshalbleitermoduls gebildet durch Kontaktverbinder, die als Kontaktfedern ausgebildet sind, und die in einer Haltevorrichtung zwischen Verbindungsbahnen und auf einer Leiterplatte angeordneten Kontaktpunkten angeordnet sind. Die Leiterplatte weist Leiterbahnen auf, die diese Kontaktpunkte mit nach außen führenden Konaktelementen, die ebenfalls auf dieser Leiterplatte angeordnet sind, verbindet. Die Leiterplatte ist innerhalb eines rahmenartig ausgebildeten Deckels eingebettet und somit selbst einen Teil des Deckels bildet.

Vorteilhafterweise kann durch Anordnung weiteren Bauelemente auf der Leiterplatte die Funktionalität des Leistungshalbleitermoduls erhöht werden.

Vorteilhaft an dieser Ausgestaltung eines Leistungshalbleitermoduls ist, dass die äußere Anschlussbelegung unabhängig von der inneren gewählt werden kann. Somit müssen beispielhaft Treiberplatinen bei einer Änderung des oder der Substrate und / oder der Art oder Anzahl der Leistungshalbleiterbauelemente nicht verändert werden.

Die Erfindung wird anhand von den Fig. 1 bis 6 näher erläutert.
- Fig. 1: zeigt ein Teilmodul eines Leistungshalbteitermoduls in Draufsicht, das einige Merkmale des erfindungsgemäßen Leistungshalbleitermodule enthält.
- Fig. 2: zeigt eine Ausgestaltung eines Leistungshalbleitermoduls in Seitenansicht, das einige Merkmale des erfindungsgemäßen Leistungshalbleitermodule enthält.
- Fig. 3: zeigt eine Ausgestaltung eines erfindungsgemäßen Leistungshalbleitermoduls in Seitenansicht.
- Fig. 4: zeigt eine Ausgestaltung eines Leistungshalbleitermoduls in Seitenansicht, das einige Merkmale des erfindungsgemäßen Leistungshalbleitermodule enthält.
- Fig. 5: zeigt eine erfindungsgemäße Ausgestaltung eines intelligenten Leistungshalbleitermoduls in Seitenansicht.
- Fig. 6: zeigt eine Anordnung von drei erfindungsgemäßen Leistungshalbleitermodulen in dreidimensionaler Ansicht.

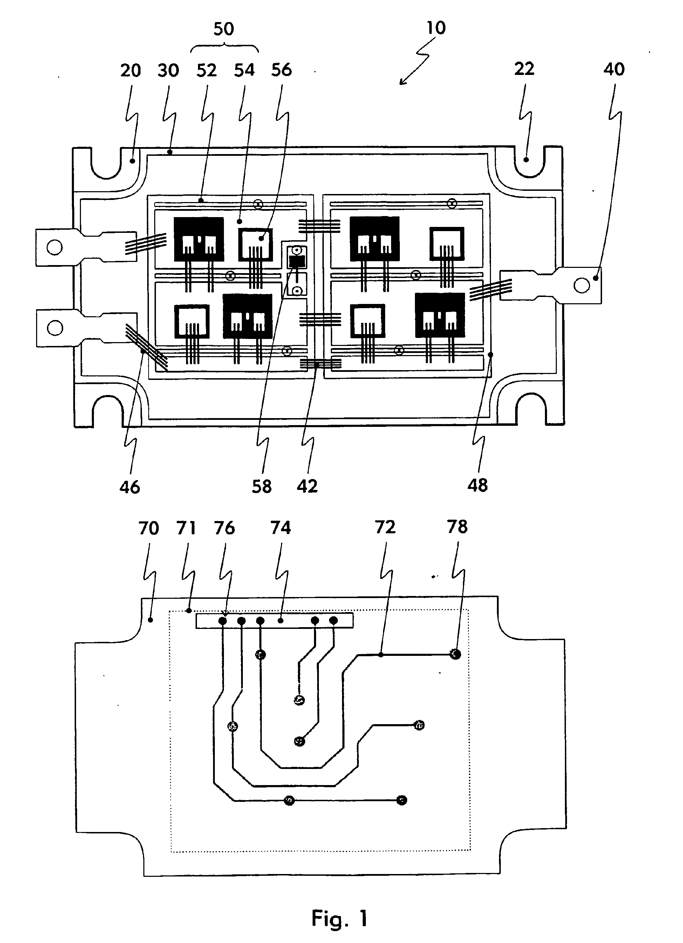

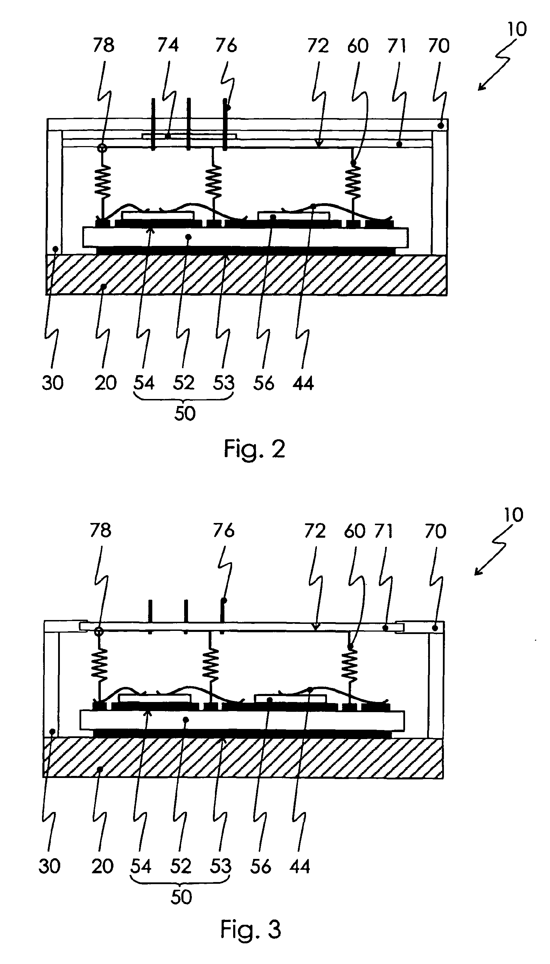

Fig. 1 zeigt ein Leistungshalbleitermoduls in Draufsicht. Dargestellt ist ein Leistungshalbleitermodul (10) bestehend aus einer Grundplatte (20) zur Montage auf einem Kühlkörper. Hierzu weist diese Grundplatte (20) im Bereich ihrer Ecken jeweils eine Ausnehmung (22) auf. Das Modul besteht weiterhin aus einem rahmenartigen Gehäuse (30) sowie zwei elektrisch isolierenden Substraten (50). Das jeweilige Substrat besteht seinerseits aus einem Isolierstoffkörper (52) mit einer Mehrzahl von auf seiner ersten der Grundplatte abgewandten Hauptfläche befindlichen gegeneinander isolierten metallischen Verbindungsbahnen (54). Auf seiner zweiten der Grundplatte zugewandten Hauptfläche weist das Substrat eine den Verbindungsbahnen der ersten Hauptfläche gleichartige flächige Metallisierung (53, Fig. 2) auf. Auf den Verbindungsbahnen (54) und mit diesen schaltungsgerecht mittels Drahtbondverbindungen (58) verbunden sind Leistungshalbleiterbauelemente (56), sowie ein Sensorikbauteil (58) angeordnet. Zur elektrischen Kontaktierung weist das Teilmodul (10) Anschlusselemente (40) für die Lastanschlüsse auf. Die Verbindungsbahnen (54) der Substrate (50) sind zum Teil miteinander und mit den Anschlusselementen (40) mittels Drahtbondverbindungen (42, 44, 46) verbunden.

Weiterhin weist das Leistungshalbleiterbauelement Federkontakte (60) auf, die in einem nicht dargestellten Hilfsrahmen angeordnet sind. Diese Federkontakte (60) verbinden die Verbindungsbahnen (54) mit Kontaktpunkten auf einer Leiterplatte (71). Diese Kontaktpunkte sind auf der Unterseite der Leiterplatte (71) angeordnet, die weiterhin auf dieser, dem Substrat (50) zugewandten Unterseite Leiterbahnen (72) aufweist. Diese verbinden die Kontaktpunkte (78) mit nach außen führenden Hilfskontaktelementen, hier Steckstiftverbindern (74). Alternativ sind hierzu beispielhaft auch Lötösen oder Lötstifte mögliche Kontaktelemente. Diese Kontaktelemente durchdringen den Deckel (70) und stellen somit die äußere Anschlussbelegung dar. Diese äußere Anschlussbelegung weicht von der durch die Kontaktstellen der Federkontakte auf dem Substrat (50) dargestellten inneren Anschlussbelegung deutlich ab. Somit gestattet das Leistungshalbleiterbauelement eine von der inneren völlig unabhängige äußere Anschlussbelegung.

Die Fig. 2 bis 5 zeigen verschiedene Leistungshalbleitermodule (10) mit einem rahmenartigen Gehäuse (30) in der Seitenansicht. Auf der Grundplatte (20) angeordnet ist ein sog. DCB (Direct Copper Bonding) Substrat (50). Dieses besteht aus einem Isolierstoffkörper (52), beispielhaft einer Aluminiumoxid- oder Aluminiumnitridkeramik, mit auf seiner der Grundplatte zugewandten Seite flächigen (53) und auf seiner der Grundplatte (20) abgewandten Seite struktruierten Kupferschicht (54). Diese Kupferschicht (54) stellt die Verbindungsbahnen des Leistungshalbleitermoduls dar. Auf diesen Verbindungsbahnen (54) sind die Bauelemente (56), in der Regel Leistungshalbleiterbauelemente und Sensorikbauteile, angeordnet. Die schaltungsgerechten Verbindungen erfolgen mittels Drahtbondverbindungen (44).

In Fig. 2 werden die Hilfsanschusselemente im ersten Teil ihres Verlaufs mittels Kontaktfedern (60) gebildet, die zwischen Kontaktstellen auf den Verbindungsbahnen (54) und Kontaktpunkten (78) auf einer Leiterplatte (71) angeordnet sind. Im weiteren werden die Anschlusselemente durch Leiterbahnen (72) auf der Leiterplatte (71) und durch nach außen führende Kontaktstiften (74) eines ebenfalls auf der Leiterplatte angeordneten Stiftsteckverbinders (76)gebildet, wobei die Kontaktstifte (76) den Deckel (70) durchdringen.

In Fig. 3 werden die Hilfsanschlusselemente im ersten Teil ihres Verlaufs ebenfalls mittels Kontaktfedern (60) und auf einer Leiterplatte angeordneter Leiterbahnen (72) gebildet. Die Leiterplatte, auf deren Kontaktpunkten (78) diese Kontaktfedern enden, ist allerdings integraler Bestandteil des Deckels (70). Der Deckel ist hier rahmenartig ausgebildet und umschließt die Leiterplatte an ihren Kanten, ohne sie vollständig zu überdecken. Die Kontaktelemente (76) für die äußere Kontaktierung werden durch Lötstifte, die die Leiterplatte (71) durchdringen, gebildet.

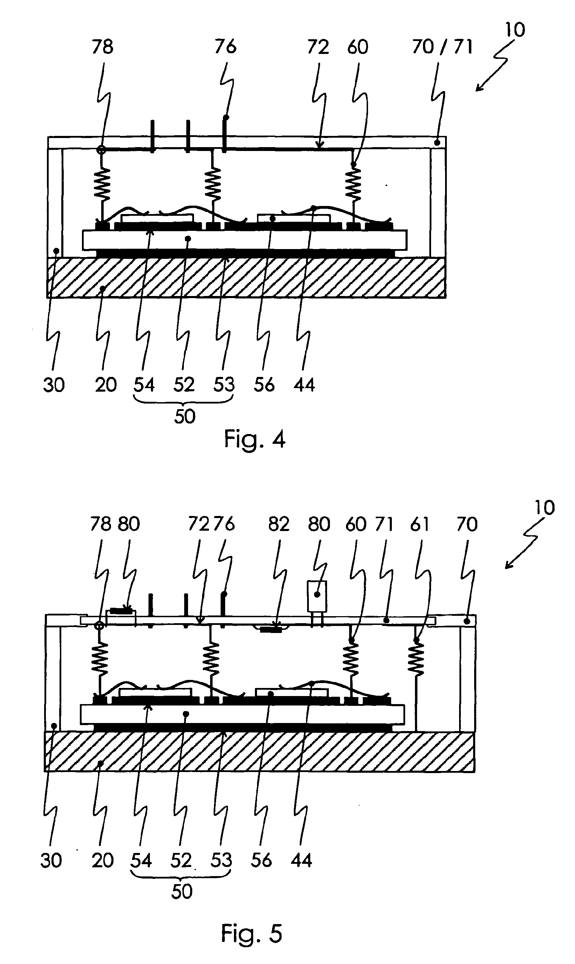

In Fig. 4 wird die modernste und einfachste Konstruktion dargestellt, die nicht beansprucht ist. Hierbei wird der Deckel (70) selbst als Leiterplatte ausgebildet, indem auf seiner Innenseite Leiterbahnen (72) direkt angeordnet sind. Derartige Verfahren sind beispielhaft als MID (Molded Interconnect Devices) bekannt. Die Kontaktelemente (76) sind hier in den Kunststoff des Deckels (70) eingespritzte Lötstifte.

Fig. 5 zeigt ein erfahrungsgemäßes Leistungshalbleitermodul gemäß Fig. 3 mit einer erhöhten Funktonalität. Durch die Anordnung von weiteren aktiven und / oder passiven Bauelementen, wie Widerständen, Kondensatoren oder integrierten Schaltungen, wird aus dem bekannten Leistungshalbleitermodul ein intelligentes Leistungshalbleitermodul, da hier teilweise die Funktonalität einer Treiber- oder sonstigen Schaltung (Auswerte-, Sensorikbeschaltung) direkt in bzw. auf dem Modul angeordnet wird.

Fig. 5 zeigt weiterhin einen zusätzlichen Kontaktverbinder, eine Kontaktfeder (60), der die Grundplatte (60) und damit auch den Kühlkörper elektrisch leitend mit der Leiterplatte (71) verbindet. Somit wird an der Leiterplatte (71) dieses Potential für dort beispielhaft angeordnete Auswerteschaltungen zur Verfügung gestellt.

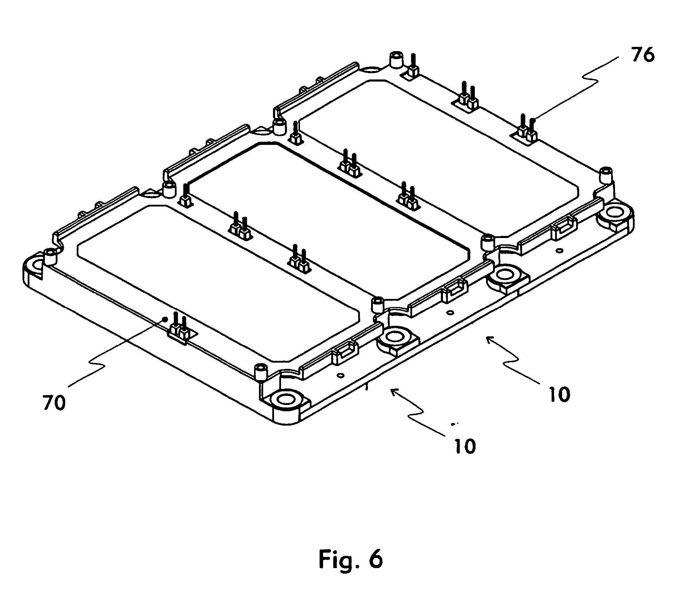

Fig. 6 zeigt eine Anordnung von drei erfindungsgemäßen Leistungshalbleitermodulen in dreidimensionaler Ansicht. Hierbei bilden drei Leistungshalbleitermodule (10) mit jeweils einer Halbbrückenschaltung eine 3-Phasen Brückenschaltung. Ein gemeinsamer Deckel (70) mit einer Anordnung der Leiterbahnen (72) und Kontaktelementen (76) gemäß Fig. 5 überdeckt alle drei Einzelmodule (10).

## Patentansprüche

1. Leistungshalbleitermodul (10) mit einer Grundplatte (20) oder zur direkten Montage auf einem Kühlkörper, das Leistungshalbleitermodul bestehend aus einem rahmenartigen Gehäuse (30), einem Deckel (70) und mit mindestens einem innerhalb des Gehäuses (30) angeordneten elektrisch isolierenden Substrat (50), das seinerseits besteht aus einem Isolierstoffkörper (52) mit einer Mehrzahl von darauf befindlichen gegeneinander isolierten metallischen Verbindungsbahnen (54), darauf befindlichen und mit diesen Verbindungsbahnen schaltungsgerecht verbundenen Leistungshalbleiterbauelementen (56) sowie nach außen führenden Anschlusselementen für Last- und Hilfskontakte, wobei zumindest ein Teil der Anschlusselemente der Hilfskontakte im Inneren des Leistungshalbleitermoduls gebildet wird durch Kontaktverbinder (60), die zwischen Verbindungsbahnen (54) und Kontaktpunkten (78) auf einer Leiterplatte (71) angeordnet sind und wobei diese Leiterplatte Leiterbahnen (72) aufweist, die diese Kontaktpunkte mit nach außen führenden Kontaktelementen (76) verbindet, wobei diese Kontaktelemente (76) an einer anderen Position der Leiterplatte als die Kontaktpunkte (78) angeordnet sind und, diese Kontaktverbinder (60) als Kontaktfedern ausgebildet sind und wobei die Leiterplatte (71) innerhalb eines rahmenartig ausgebildeten Deckels (70) eingebettet ist und somit selbst einen Teil des Deckels (70) bildet.

2. Leistungshalbleitermodul (10) nach Anspruch 1, wobei
auf der Leiterplatte (71) aktive und / oder passive elektronische Bauelemente (80, 82) angeordnet und schaltungsgerecht mit den Leiterbahnen (72) dieser Leiterplatte verbunden sind.

3. Leistungshalbleitermodul nach Anspruch 1 oder 2, wobei
dieses Leistungshalbleitermodul (10) mindestens einen Kontaktverbinder (60) aufweist, der mit der Grundplatte (20) oder mit einem Kühlkörper verbunden ist.

4. Leistungshalbleitermodul nach Anspruch 1 oder 2, wobei
die Kontaktelemente als Steckstiftverbinder oder Lötösen ausgebildet sind.

5. Leistungshalbleitermodul nach Anspruch 1 oder 2, wobei
mindestens ein Substrat (50) ein Sensorikbauteil aufweist.

## Claims

1. A power semiconductor module (10) with a baseplate (20), or for direct mounting onto a cooling body, the power semiconductor module consisting of a frame-type housing (30), a cover (70) and with at least one electrically insulating substrate (50) arranged within the housing (30), which substrate for its part consists of a body of insulating material (52) with located on it a number of metallic connecting traces (54) insulated from one another and power semiconductor components (56) connected with these connecting traces in a manner appropriate to the circuit, and also terminal elements that are routed outwards for load and ancillary contacts, wherein
at least a proportion of the terminal elements of the ancillary contacts are formed in the interior of the power semiconductor module by contact connectors (60), which are arranged between connecting traces (54) and contact points (78) on a printed circuit board (71), and wherein
this printed circuit board has conductive traces (72) that connect these contact points with contact elements (76) that are routed outwards, wherein
these contact elements (76) are arranged at a location on the printed circuit board other than that of the contact points (78), these contact connectors (60) are designed as contact springs, and wherein
the printed circuit board (71) is embedded within a cover designed as a type of frame (70), and thus itself forms a part of the cover (70).

2. The power semiconductor module (10) according to Claim 1, wherein
active and/or passive electronic components (80, 82) are arranged on the printed circuit board (71) and are connected in a manner appropriate to the circuit with the conductive traces (72) of this printed circuit board.

3. The power semiconductor module according to Claim 1 or 2, wherein
this power semiconductor module (10) has at least one contact connector (60) that is connected with the baseplate (20), or with a cooling body.

4. The power semiconductor module according to Claim 1 or 2, wherein
the contact elements are designed as pin connectors or solder lugs.

5. The power semiconductor module according to Claim 1 or 2, wherein
at least one substrate (50) has a sensor system component.

## Revendications

1. Module à semi-conducteurs de puissance (10) avec une plaque de base (20) ou pour le montage direct sur un corps de refroidissement, le module à semi-conducteurs de puissance étant constitué d'un boîtier (30) en forme de cadre, un couvercle (70) et avec au moins un substrat (50) disposé à l'intérieur du boîtier (30) et électro-isolant, lequel est constitué pour sa part d'un corps en matière isolante (52) avec une pluralité de pistes de liaison (54) métalliques se trouvant dessus et isolées les unes par rapport aux autres, de composants à semi-conducteurs de puissance (56) se trouvant dessus et reliés à ces pistes de liaison de façon conforme au montage ainsi que d'éléments de raccordement allant vers l'extérieur pour des contacts de charge et des contacts auxiliaires, au moins une partie des éléments de raccordement des contacts auxiliaires à l'intérieur du module à semi-conducteurs de puissance étant formée par des connecteurs de contact (60) qui sont disposés entre des pistes de liaison (54) et des points de contact (78) sur une carte à circuits imprimés (71) et cette carte à circuits imprimés présentant des pistes conductrices (72), qui relie ces points de contact à des éléments de contact (76) allant vers l'extérieur, ces éléments de contact (76) étant disposés dans une autre position de la carte à circuits imprimés en tant que points de contact (78) et ces connecteurs de contact (60) étant réalisés sous forme de ressorts de contact et la carte à circuits imprimés (71) étant enfoncée à l'intérieur d'un couvercle (70) conçu sous forme de cadre et formant ainsi même une partie du couvercle (70).

2. Module à semi-conducteurs de puissance (10) selon la revendication 1,
des composants (80, 82) électroniques actifs et/ou passifs étant disposés sur la carte à circuits imprimés (71) et étant reliés conformément au montage aux pistes conductrices (72) de cette carte à circuits imprimés.

3. Module à semi-conducteurs de puissance selon la revendication 1 ou 2,
ce module à semi-conducteurs de puissance (10) présentant au moins un connecteur de contact (60), qui est relié à la plaque de base (20) ou à un corps de refroidissement.

4. Module à semi-conducteurs de puissance selon la revendication 1 ou 2, les éléments de contact étant conçus sous la forme de connecteurs à broches emboîtables ou de cosses à souder.

5. Module à semi-conducteurs de puissance selon la revendication 1 ou 2, au moins un substrat (50) présentant un composant de détection.
